# EUROPEAN PATENT APPLICATION

(11) **EP 4 343 835 A1**
(43) Date of publication of application: **27.03.2024**
(21) Application number: 21945408.9
(22) Date of filing: 15.06.2021
(51) Int. Cl.: H01L 23/538

(54) **CHIP STACKING STRUCTURE AND MANUFACTURING METHOD, WAFER STACKING STRUCTURE, AND ELECTRONIC DEVICE**

(71) Applicant: Huawei Technologies Co., Ltd., Shenzhen, Guangdong 518129 (CN)
(72) Inventor: GAO, Shan, Shenzhen, Guangdong 518129 (CN); ZHU, Jifeng, Shenzhen, Guangdong 518129 (CN); LEI, Dian, Shenzhen, Guangdong 518129 (CN); ZHU, Jinghua, Shenzhen, Guangdong 518129 (CN); ZHANG, hongying, Shenzhen, Guangdong 518129 (CN)
(74) Representative: Körber, Martin Hans
(86) International application number: PCT/CN2021/100036
(87) International publication number: WO 2022/261815

(57) **Abstract**

Embodiments of this application relate to the field of semiconductor technologies and provide a chip stacking structure and a manufacturing method therefor, a wafer stacking structure, and an electronic device to resolve problems of low chip bonding strength and limited space for disposing an interconnection structure in a 3D-IC stacking process. The chip stacking structure includes a first chip, a second chip, and a third chip that are sequentially stacked. A rear surface of the second chip faces an active surface of the first chip. A rear surface of the third chip faces the active surface of the first chip. In the chip stacking structure, the first chip and the second chip are bonded using a hybrid bonding process, and the third chip and the second chip are bonded using the hybrid bonding process. In addition, the chip stacking structure further includes a first via that penetrates the second chip. The first chip performs signal transmission with the second chip and the third chip through the first via.

## Description

### TECHNICAL FIELD

This application relates to the field of semiconductor technologies, and in particular, to a chip stacking structure and a manufacturing method therefor, a wafer stacking structure, and an electronic device.

### BACKGROUND

As a semiconductor process develops, an electronic device tends to be increasingly miniaturized but has increasingly diversified functions to meet user requirements. As a result, a component with high integration and performance needs to be disposed in limited two-dimensional component layout space of the electronic device. Currently, a plurality of chips can be stacked one by one in a longitudinal direction using a three-dimensional (3 dimensions, 3D) integrated circuit (integrated circuit chip, IC) stacking technology to form the component. As a quantity of stacked chips in the component increases, when strength of bonding between the chips is low, the component is prone to damage during use. In addition, two adjacent chips need to be coupled to each other through an interconnection structure to implement signal transmission. However, with the increase in the quantity of chips and miniaturization of the chips, space for disposing the interconnection structure is increasingly limited. Consequently, performance of the component is reduced.

### SUMMARY

Embodiments of this application provide a chip stacking structure and a manufacturing method therefor, a wafer stacking structure, and an electronic device to resolve problems of low chip bonding strength and limited space for disposing an interconnection structure in a 3D-IC stacking process.

To achieve the foregoing objective, the following technical solutions are used in this application.

According to a first aspect of embodiments of this application, a chip stacking structure is provided. The chip stacking structure includes a first chip, a second chip, and a third chip. The second chip is disposed on a side on which an active surface of the first chip is located. A passive surface of the second chip faces the active surface of the first chip. The first chip and the second chip are bonded using a hybrid bonding process. The third chip is disposed on a side on which an active surface of the second chip is located. A passive surface of the third chip faces the active surface of the second chip. The second chip and the third chip are bonded using the hybrid bonding process. In addition, the chip stacking structure further includes a first via. The first via penetrates the second chip. A first end of the first via is coupled to the first chip. A second end of the first via is coupled to the second chip and the third chip.

In conclusion, the chip stacking structure may include a plurality of stacked chips, so that high integration can be achieved in a longitudinal direction, a size of the chip stacking structure in a two-dimensional plane is reduced, and a component with high integration and performance can be provided in limited two-dimensional component layout space of an electronic device. In addition, the first chip and the second chip in the chip stacking structure are bonded using the hybrid bonding process. Therefore, the first chip and the second chip can be bonded not only through an insulation material, but also through a metal material. In comparison with a solution in which two chips are bonded through a single material, for example, an insulation material, higher bonding strength can be achieved through hybrid bonding between the first chip and the second chip. In addition, the metal material through which the first chip and the second chip are bonded can further couple the first chip and the second chip. Similarly, the second chip and the third chip are also bonded using the hybrid bonding process. Therefore, bonding strength is also high. In addition, a metal material through which the second chip and the third chip are bonded can further couple the second chip and the third chip. On this basis, the chip stacking structure further includes the first via that penetrates the second chip. The first via can couple the first chip and the third chip. In this way, because the first chip and the second chip can be coupled using the hybrid bonding process, and the second chip and the third chip can be coupled using the hybrid bonding process, the first chip, the second chip, and the third chip can be coupled by coupling the first chip and the third chip through the first via. In this way, there is no need to separately dispose an interconnection structure, for example, the via, between the first chip and the second chip. There is also no need to separately dispose a via between the second chip and the third chip. This can reduce a quantity of vias and space for disposing an interconnection structure in the chip. In this way, in a 3D-IC stacking process, bonding strength of adjacent chips is improved, and a problem of limited space for disposing an interconnection structure is resolved.

Optionally, the chip stacking structure further includes a first dielectric layer, a plurality of first dummy pads arranged at intervals, a second dielectric layer, a plurality of second dummy pads arranged at intervals, a third dielectric layer, a plurality of third dummy pads arranged at intervals, a fourth dielectric layer, and a plurality of fourth dummy pads arranged at intervals. The first dielectric layer is disposed on the active surface of the first chip. The first dummy pads are disposed in the first dielectric layer. The second dielectric layer is disposed on the passive surface of the second chip. The second dummy pads are disposed in the second dielectric layer. To enable the first chip and the second chip to be bonded using the hybrid bonding process, the first dielectric layer and the second dielectric layer between the first chip and the second chip are bonded. In addition, one of the plurality of second dummy pads is bonded to one of the plurality of first dummy pads. The third dielectric layer is disposed on the active surface of the second chip. The third dummy pads are disposed in the third dielectric layer. The fourth dielectric layer is disposed on the passive surface of the third chip. The fourth dummy pads are disposed in the fourth dielectric layer. To enable the second chip and the third chip to be bonded using the hybrid bonding process, the third dielectric layer and the fourth dielectric layer between the second chip and the third chip are bonded. In addition, one of the plurality of fourth dummy pads is bonded to one of the plurality of third dummy pads.

Optionally, the chip stacking structure further includes a first redistribution layer, a second conductive pad, a second redistribution layer, and a third conductive pad. The first redistribution layer is disposed in the first dielectric layer and coupled to the first chip. The second conductive pad is disposed in the second dielectric layer and coupled to the first redistribution layer. The second redistribution layer is disposed in the third dielectric layer and coupled to the second chip. The third conductive pad is disposed in the fourth dielectric layer and coupled to the second redistribution layer and the third chip. The first end of the first via is coupled to the second conductive pad. The second end of the first via is coupled to the second redistribution layer. In this way, the first redistribution layer, the second conductive pad, the first via, the second redistribution layer, and the third conductive pad may form a first interconnection component. Because the third conductive pad is coupled to the third chip, signal transmission can be implemented between the first chip, the second chip, and the third chip through the first interconnection component. Because the first via in the first interconnection component penetrates the second chip and a substrate in the second chip has a small thickness that may be approximately 50 µm, the first chip, the second chip, and the third chip can be coupled in the longitudinal direction through the first interconnection component, so that a signal transmission path of the first chip, the second chip, and the third chip is shorter. In this case, in comparison with a solution in which two or three side-by-side chips are coupled through a trace in the two-dimensional plane, a signal transmitted by the chip stacking structure provided in this application can have higher bandwidth. This helps improve performance of the chip stacking structure.

Optionally, the chip stacking structure further includes a first conductive pad, disposed on a surface that is of the first redistribution layer and that is away from the first chip, and coupled to the first redistribution layer. The first conductive pad is bonded to the second conductive pad. The first conductive pad is bonded to the second conductive pad, so that the second conductive pad is coupled to a metal trace in the first redistribution layer through the first conductive pad, and strength of bonding between the first chip and the second chip is improved.

Optionally, the chip stacking structure further includes a fourth conductive pad, disposed on a surface that is of the second redistribution layer and that is away from the second chip, and coupled to the second redistribution layer. The fourth conductive pad is bonded to the third conductive pad. The fourth conductive pad is bonded to the third conductive pad, so that the third conductive pad is coupled to a metal trace in the second redistribution layer through the fourth conductive pad, and strength of bonding between the third chip and the second chip is improved.

Optionally, the chip stacking structure further includes a fifth dielectric layer, a plurality of interface pads arranged at intervals, a third redistribution layer, and a second via. The fifth dielectric layer is disposed on an active surface of the third chip. The plurality of interface pads are disposed in the fifth dielectric layer and configured to be coupled to an external component. The third redistribution layer is disposed in the fifth dielectric layer and coupled to the third chip. The second via penetrates the third chip. A first end of the second via is coupled to the third conductive pad. A second end of the second via is coupled to the third redistribution layer. In this way, each chip in the chip stacking structure can be coupled to the external component through the interface pad. In addition, the third redistribution layer and the second via may form a second interconnection component, so that the third chip can implement signal transmission with the second chip and the first chip in the chip stacking structure through the second interconnection component and the first interconnection component coupled to the second interconnection component. As described above, the second via in the second interconnection component penetrates the third chip. Therefore, the second chip and the third chip can be coupled in the longitudinal direction through the second interconnection component, so that a signal transmission path of the second chip and the third chip is shorter. This helps improve performance of the chip stacking structure.

Optionally, the third chip is a logic chip. At least one of the first chip or the second chip is a memory chip. In this way, the chip stacking structure can form a high bandwidth memory.

Optionally, the first chip is a logic chip. The second chip is a memory chip. The third chip is a pixel array circuit. The pixel array circuit includes a plurality of photosensitive pixels and optical-to-electrical conversion elements located in the photosensitive pixels. Light incidence surfaces of the optical-to-electrical conversion elements are disposed away from the second chip. In this way, the chip stacking structure can be used to form an image sensor. The memory chip, the logic chip, and the pixel array circuit in the image sensor are stacked, so that a final actual photosensitive area of the chip stacking structure can be increased while a same chip size is ensured because the memory chip, the logic chip, and the photosensitive pixels in the pixel array circuit are not at a same layer.

Optionally, the chip stacking structure further includes a plurality of fifth conductive pads arranged at intervals and a plurality of sixth conductive pads arranged at intervals. The plurality of fifth conductive pads are disposed in the first dielectric layer and electrically connected to the first chip. The plurality of sixth conductive pads are disposed in the second dielectric layer and electrically connected to the second chip. One of the plurality of fifth conductive pads is bonded to one of the plurality of sixth conductive pads. In this way, in a process of bonding the first chip and the second chip, when the first dielectric layer and the second dielectric layer are bonded and one of the first dummy pads and one of the second dummy pads are bonded, one of the fifth conductive pads and one of the sixth conductive pads may also be bonded. This further improves the strength of the bonding between the first chip and the second chip. In addition, signal transmission can be implemented between the first chip and the second chip not only through the first interconnection component, but also through the fifth conductive pad and the sixth conductive pad that are coupled to each other. This can increase signal bandwidth of the chip stacking structure.

Optionally, the chip stacking structure further includes a plurality of seventh conductive pads arranged at intervals and a plurality of eighth conductive pads arranged at intervals. The plurality of seventh conductive pads are disposed in the third dielectric layer and electrically connected to the second chip. The plurality of eighth conductive pads are disposed in the fourth dielectric layer and electrically connected to the third chip. One of the plurality of seventh conductive pads is bonded to one of the plurality of eighth conductive pads. In this way, in a process of bonding the second chip and the third chip, when the second dielectric layer and the third dielectric layer are bonded and one of the third dummy pads and one of the fourth dummy pads are bonded, one of the seventh conductive pads and one of the eighth conductive pads may also be bonded. This further improves the strength of the bonding between the second chip and the third chip. In addition, signal transmission can be implemented between the second chip and the third chip not only through the first interconnection component, but also through the seventh conductive pad and the eighth conductive pad that are coupled to each other. This can increase signal bandwidth of the chip stacking structure.

According to a second aspect of embodiments of this application, a wafer stacking structure is provided. The wafer stacking structure includes a first wafer, a second wafer, and a third wafer. The second wafer is disposed on a side on which an active surface of the first wafer is located. A passive surface of the second wafer faces the active surface of the first wafer. The first wafer and the second wafer are bonded using a hybrid bonding process. The third wafer is disposed on a side on which an active surface of the second wafer is located. A passive surface of the third wafer faces the active surface of the second wafer. The second wafer and the third wafer are bonded using the hybrid bonding process. In addition, the wafer stacking structure further includes a first via. The first via penetrates the second wafer. A first end of the first via is coupled to the first wafer. A second end of the first via is coupled to the second wafer and the third wafer. The wafer stacking structure has a same technical effect as the chip stacking structure provided in the foregoing embodiment. Details are not described herein again.

Optionally, the wafer stacking structure further includes a first dielectric layer, a plurality of first dummy pads arranged at intervals, a second dielectric layer, a plurality of second dummy pads arranged at intervals, a third dielectric layer, a plurality of third dummy pads arranged at intervals, a fourth dielectric layer, and a plurality of fourth dummy pads arranged at intervals. The first dielectric layer is disposed on the active surface of the first wafer. The first dummy pads are disposed in the first dielectric layer. The second dielectric layer is disposed on the passive surface of the second wafer. The second dummy pads are disposed in the second dielectric layer. To enable the first wafer and the second wafer to be bonded using the hybrid bonding process, the first dielectric layer and the second dielectric layer between the first wafer and the second wafer are bonded. In addition, one of the plurality of second dummy pads is bonded to one of the plurality of first dummy pads. The third dielectric layer is disposed on the active surface of the second wafer. The third dummy pads are disposed in the third dielectric layer. The fourth dielectric layer is disposed on the passive surface of the third wafer. The fourth dummy pads are disposed in the fourth dielectric layer. To enable the second wafer and the third wafer to be bonded using the hybrid bonding process, the third dielectric layer and the fourth dielectric layer between the second wafer and the third wafer are bonded. In addition, one of the plurality of fourth dummy pads is bonded to one of the plurality of third dummy pads.

Optionally, the wafer stacking structure further includes a first redistribution layer, a second conductive pad, a second redistribution layer, and a third conductive pad. The first redistribution layer is disposed in the first dielectric layer and coupled to the first wafer. The second conductive pad is disposed in the second dielectric layer and coupled to the first redistribution layer. The second redistribution layer is disposed in the third dielectric layer and coupled to the second wafer. The third conductive pad is disposed in the fourth dielectric layer and coupled to the second redistribution layer and the third wafer. The first end of the first via is coupled to the second conductive pad. The second end of the first via is coupled to the second redistribution layer. A technical effect of a first interconnection component formed by the first redistribution layer, the second conductive pad, the first via, the second redistribution layer, and the third conductive pad is the same as that described above. Details are not described herein again.

Optionally, the wafer stacking structure further includes a fifth dielectric layer, a plurality of interface pads arranged at intervals, a third redistribution layer, and a second via. The fifth dielectric layer is disposed on an active surface of the third wafer. The plurality of interface pads are disposed in the fifth dielectric layer and configured to be coupled to an external component. The third redistribution layer is disposed in the fifth dielectric layer and coupled to the third wafer. The second via penetrates the third wafer. A first end of the second via is coupled to the third conductive pad. A second end of the second via is coupled to the third redistribution layer. Technical effects of the interface pad and a second interconnection component formed by the second via and the third redistribution layer are the same as those described above. Details are not described herein again.

According to a third aspect of embodiments of this application, an electronic device is provided, including an external component and at least one chip stacking structure as described above coupled to the external component. The electronic device has a same technical effect as the chip stacking structure provided in the foregoing embodiment. Details are not described herein again.

Optionally, the external component includes at least one of the following: a package substrate, an interposer, or at least one redistribution layer of a fan-out package. In this case, a bottom chip in the chip stacking structure can implement signal transmission with a PCB through the external component.

According to a fourth aspect of embodiments of this application, a method for manufacturing a wafer stacking structure is provided. The method includes: disposing a second wafer on a side on which an active surface of a first wafer is located and bonding the first wafer and the second wafer using a hybrid bonding process, where a passive surface of the second wafer faces the active surface of the first wafer; disposing a third wafer on a side on which an active surface of the second wafer is located and bonding the third wafer and the second wafer using the hybrid bonding process, where a passive surface of the third wafer faces the active surface of the second wafer; and forming a first via that penetrates the second wafer A first end of the first via is coupled to the first wafer. A second end of the first via is coupled to the third wafer.

The method for manufacturing a wafer stacking structure has a same technical effect as the chip stacking structure provided in the foregoing embodiment. Details are not described herein again. In addition, it can be learned from the foregoing manufacturing method that in a process of manufacturing the chip stacking structure provided in embodiments of this application, the first wafer (cut to obtain the first chip) and the second wafer (cut to obtain the second chip) may be sequentially stacked through wafer to wafer bonding (wafer to wafer bonding, W2W bonding). Next, a stacking component formed by the first wafer and the second wafer is bonded to the third wafer (cut to obtain the third chip) through W2W bonding to form the wafer stacking structure. In this case, the wafer stacking structure may be cut along cutting lines on an outermost wafer of the wafer stacking structure, to form a plurality of chip stacking structures. Therefore, in the process of manufacturing the chip stacking structure, alignment (alignment) needs to be performed only on the wafers, but does not need to be performed on a single chip. This helps reduce alignment precision and improve production efficiency. In addition, in comparison with a chip (or referred to as die) to chip (die to die, D2D) bonding solution and a chip to wafer (die to wafer, D2W) bonding solution, in the W2W bonding solution provided in embodiments of this application, the wafers are directly bonded and then cut to obtain the chip stacking structures 20. Therefore, there is no need to use a known good die (known good die, KGD) to test dies obtained through cutting one by one, so that a manufacturing process can be simplified and production costs can be reduced. In addition, no organic adhesive layer needs to be added in a process of bonding any two wafers. Therefore, a probability of organic impurity contamination caused by use of an organic material can be reduced in the process of manufacturing the chip stacking structure. Furthermore, a wafer carrier plate can support the second wafer in both a process of thinning the passive surface of the second wafer and a process of bonding the passive surface of the second wafer and the active surface of the first wafer, so that a probability that the second wafer warps during the thinning and stacking with another wafer can be reduced. This can improve yields of the wafer stacking structure and the chip stacking structure formed by cutting the wafer stacking structure.

Optionally, the disposing a second wafer on a side on which an active surface of a first wafer is located and bonding the first wafer and the second wafer using a hybrid bonding process includes: forming a first dielectric layer on the active surface of the first wafer, and forming a plurality of first dummy pads arranged at intervals in the first dielectric layer; forming a third dielectric layer on the active surface of the second wafer, bonding a wafer carrier plate to a surface that is of the third dielectric layer and that is away from the second wafer, and thinning the passive surface of the second wafer; forming a second dielectric layer on the passive surface of the second wafer, and forming a plurality of second dummy pads arranged at intervals in the second dielectric layer; bonding the second dielectric layer and the first dielectric layer, bonding one of the plurality of second dummy pads and one of the plurality of first dummy pads, and removing the wafer carrier plate; and forming a plurality of third dummy pads arranged at intervals in the third dielectric layer. The disposing a third wafer on a side on which an active surface of the second wafer is located and bonding the third wafer and the second wafer using the hybrid bonding process includes: forming a fourth dielectric layer on the passive surface of the third wafer, and forming a plurality of fourth dummy pads arranged at intervals in the fourth dielectric layer; and bonding the fourth dielectric layer and the third dielectric layer, and bonding one of the plurality of fourth dummy pads and one of the plurality of third dummy pads.

Optionally, after the third wafer and the second wafer are bonded, the foregoing chip and wafer stacking method further includes: cutting the first wafer, the second wafer, and the third wafer along cutting lines to obtain a plurality of chip stacking structures.

Optionally, after the first dielectric layer is formed on the active surface of the first wafer, the method for manufacturing a wafer stacking structure further includes: forming a first redistribution layer in the first dielectric layer. After the second dielectric layer is formed on the passive surface of the second wafer and the first via is formed, the method for manufacturing a wafer stacking structure further includes: forming, in the second dielectric layer, a second conductive pad located at an end that is of the first via and that is away from the wafer carrier plate. The first end of the first via is coupled to the second conductive pad. After the third dielectric layer is formed on the active surface of the second wafer, the method for manufacturing a wafer stacking structure further includes: forming a second redistribution layer in the third dielectric layer. The second redistribution layer is coupled to the second wafer and the second end of the first via. After the fourth dielectric layer is formed on the passive surface of the third wafer, the method for manufacturing a wafer stacking structure further includes: forming a third conductive pad in the fourth dielectric layer. The third conductive pad is coupled to the second redistribution layer. A technical effect of a first interconnection component formed by the first redistribution layer, the second conductive pad, the first via, the second redistribution layer, and the third conductive pad is the same as that described above. Details are not described herein again.

Optionally, before the fourth dielectric layer is formed on the passive surface of the third wafer, the method for manufacturing a wafer stacking structure further includes: forming a fifth dielectric layer on an active surface of the third wafer, bonding the wafer carrier plate to a surface that is of the fifth dielectric layer and that is away from the third wafer, and thinning the passive surface of the third wafer. After the fourth dielectric layer is formed on the passive surface of the third wafer, a second via that penetrates the third wafer is formed, and a third conductive pad located at an end that is of the second via and that is away from the wafer carrier plate is formed in the fourth dielectric layer. A first end of the second via is coupled to the third conductive pad. After the fourth dielectric layer and the third dielectric layer are bonded, the method for manufacturing a wafer stacking structure further includes: removing the wafer carrier plate, and forming a third redistribution layer in the fifth dielectric layer. The third redistribution layer is coupled to the third wafer and a second end of the second via. Technical effects of the interface pad and a second interconnection component formed by the second via and the third redistribution layer are the same as those described above. Details are not described herein again.

### BRIEF DESCRIPTION OF DRAWINGS

FIG. 1 is a schematic diagram of a structure of an electronic device according to an embodiment of this application;
FIG. 2a is a schematic diagram of a chip stacking structure according to an embodiment of this application;
FIG. 2b is a schematic diagram of a structure of a first chip in FIG. 2a;
FIG. 2c is a schematic diagram of another chip stacking structure according to an embodiment of this application;
FIG. 3 is a flowchart of a method for manufacturing a chip stacking structure according to an embodiment of this application;
FIG. 4a, FIG. 4b, and FIG. 4c are schematic diagrams of structures corresponding to a step of manufacturing a first stacking component in sequence;
FIG. 5a and FIG. 5b are schematic diagrams of structures corresponding to a step of manufacturing a second stacking component in sequence;
FIG. 6a is a schematic diagram of a structure obtained by bonding a first stacking component shown in FIG. 4c and a second stacking component shown in FIG. 5b;
FIG. 6b is a schematic diagram of a structure obtained by manufacturing third dummy pads based on a structure shown in FIG. 6a;
FIG. 7 is a schematic diagram of a structure corresponding to a step of manufacturing a third stacking component;
FIG. 8 is a schematic diagram of a wafer stacking structure obtained by bonding a third stacking component shown in FIG. 7 and a structure shown in FIG. 6b;
FIG. 9 is a schematic diagram of another wafer stacking structure according to an embodiment of this application;
FIG. 10 is a schematic diagram of another wafer stacking structure according to an embodiment of this application;
FIG. 11a is a schematic diagram of a structure of a third chip according to an embodiment of this application;
FIG. 11b is a schematic diagram of a wafer stacking structure formed by stacking a third wafer having a third chip shown in FIG. 11a;
FIG. 12 is a schematic diagram of another chip stacking structure according to an embodiment of this application;
FIG. 13a and FIG. 13b are schematic diagrams of structures corresponding to a step of manufacturing a third stacking component in sequence;
FIG. 13c is a schematic diagram of a wafer stacking structure obtained by bonding a third stacking component shown in FIG. 13b and a structure shown in FIG. 6b;
FIG. 14 is a schematic diagram of another chip stacking structure according to an embodiment of this application; and
FIG. 15 is a schematic diagram of another chip stacking structure according to an embodiment of this application.

### Reference numerals:

01: electronic device; 10: external component; 20: chip stacking structure; 21: first stacking component; 211: first chip; 301: first dielectric layer; 22: second stacking component; 212: second chip; 302: second dielectric layer; 303: third dielectric layer; 23: third stacking component; 213: third chip; 304: fourth dielectric layer; 401: first dummy pad; 402: second dummy pad; 403: third dummy pad; 404: fourth dummy pad; 50: first interconnection component; 501: first redistribution layer; 522: second conductive pad; 511: first via; 502: second redistribution layer; 523: third conductive pad; 100: substrate; 101: circuit structure; 521: first conductive pad; 524: fourth conductive pad; 131: first wafer; 201: first groove; 202: second groove; 31: wafer carrier plate; 132: second wafer; 133: third wafer; 02: wafer stacking structure; 525: fifth conductive pad; 526: sixth conductive pad; 527: seventh conductive pad; 528: eighth conductive pad; 32: optical-to-electrical conversion element; 51: second interconnection component; 512: second via; 503: third redistribution layer; 600: interface pad; 305: fifth dielectric layer; 22b: upper second stacking component; 22a: lower second stacking component.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

The terms "first", "second", and the like mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features.

In addition, in this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

In this application, it should be noted that the term "connection" should be understood in a broad sense unless otherwise expressly specified and limited. For example, the "connection" may be a fixed connection, or may be a detachable connection or an integrated connection; and may be a direct connection, or may be an indirect connection through an intermediate medium. In addition, the term "coupling" may be a manner of implementing an electrical connection for signal transmission. The "coupling" may be a direct electrical connection, or may be an indirect electrical connection through an intermediate medium.

Embodiments of this application provide an electronic device. The electronic device includes an electronic product such as a mobile phone (mobile phone), a tablet computer (pad), a computer, an intelligent wearable product (for example, a smartwatch or a smart band), a virtual reality (virtual reality, VR) terminal device, an augmented reality (augmented reality, AR) terminal device, or the like. A specific form of the electronic device is not specifically limited in embodiments of this application.

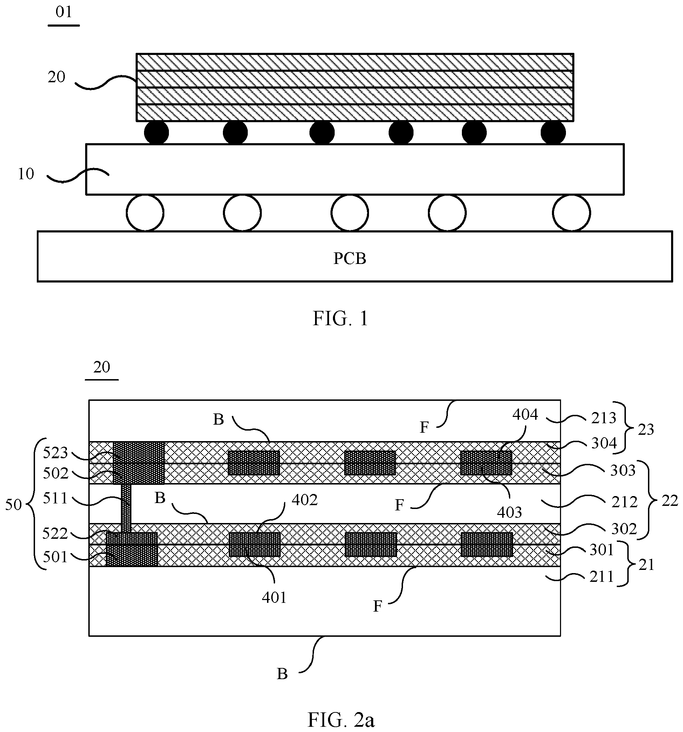

As shown in FIG. 1, an electronic device 01 includes an external component 10 and at least one chip stacking structure 20 coupled to the external component 10. The external component 10 may include at least one of a package substrate, a silicon-based interposer (interposer), and at least one redistribution layer (redistribution layer, RDL) of a fan-out (integrated fan-out, InFO) package.

The chip stacking structure 20 may include a plurality of stacked chips. The chip in the chip stacking structure 20 may be a logic chip or a memory chip. The chip stacking structure 20 may be coupled to a ball grid array (ball grid array, BGA) shown in FIG. 1, or a plurality of copper pillar bumps (copper pillar bumps) arranged in an array. In addition, the electronic device 01 further includes a printed circuit board (printed circuit board, PCB). The external component 10 may further be coupled to the PCB through an electrical connector. In this case, the chip stacking structure 20 can implement signal transmission with another chip or chip stacking structure on the PCB through the external component 10.

The following describes the chip stacking structure 20.

In some embodiments of this application, as shown in FIG. 2a (which shows a partial structure of the chip stacking structure 20), the chip stacking structure 20 may include a first chip 211, a second chip 212, and a third chip 213. For ease of description, the chip stacking structure 20 is divided into a first stacking component 21, a second stacking component 22, and a third stacking component 23 below. The first stacking component 21 may include the first chip 211. The second stacking component 22 may include the second chip 212. The third stacking component 23 may include the third chip 213.

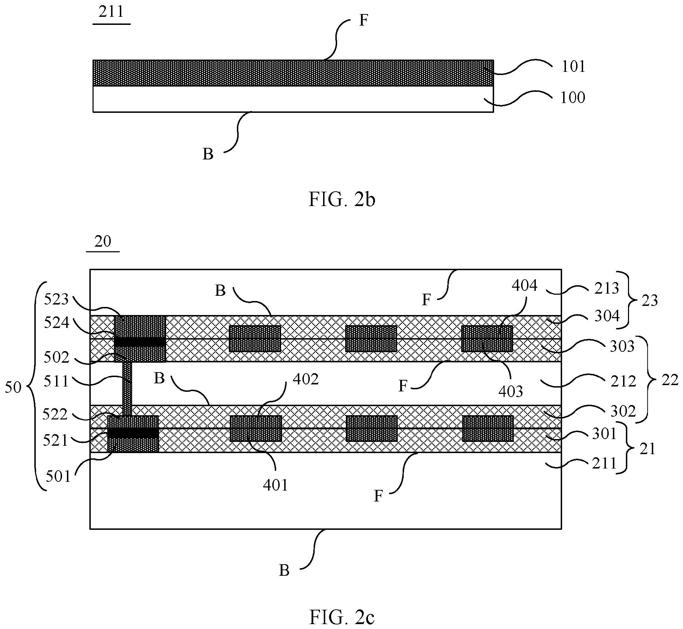

It should be noted that in embodiments of this application, any chip, for example, the first chip 211, as shown in FIG. 2b, may include a substrate 100, such as a glass substrate, an amorphous silicon (amorphous silicon, a-Si) substrate, or a silicon carbide (SiC) substrate. In addition, the first chip 211 may further include a circuit structure 101 disposed on the substrate 100. In embodiments of this application, a surface that is of the circuit structure 101 in the first chip 211 and that is away from the substrate 100 is referred to as an active surface F of the chip, and a surface that is of the substrate 100 and that is away from the circuit structure 101 is referred to as a passive surface B.

In addition, the first stacking component 21 may further include a first dielectric layer 301 and a plurality of first dummy pads (pads) 401 arranged at intervals, as shown in FIG. 2a. The first dielectric layer 301 is disposed on the active surface F of the first chip 211. The plurality of first dummy pads 401 are disposed in the first dielectric layer 301. The first dummy pads 401 are not coupled to the circuit structure 101 in the first chip 211. In embodiments of this application, the first dielectric layer 301 may be made of an inorganic insulation material. The first dummy pad 401 may be made of a conductive material, for example, at least one of gold, silver, copper, or aluminum. For example, the first dummy pad 401 may be made of pure copper.

In addition, as shown in FIG. 2a, the second stacking component 22 may include the second chip 212, a second dielectric layer 302, a third dielectric layer 303, a plurality of second dummy pads 402 arranged at intervals, and a plurality of third dummy pads 403 arranged at intervals.

Similarly, the second chip 212 includes an active surface F and a passive surface B that are opposite to each other. The second chip 212 is disposed on a side on which the active surface F of the first chip 211 is located. The passive surface B of the second chip 212 faces the active surface F of the first chip 211. The second dielectric layer 302 is disposed on the passive surface B of the second chip 212. In addition, the plurality of second dummy pads 402 are disposed in the second dielectric layer 302. One of the plurality of second dummy pads 402 corresponds to a position of one of the plurality of first dummy pads 401. The second dummy pads 402 are not coupled to the circuit structure 101 in the second chip 212.

A material of the second dielectric layer 302 is the same as that of the first dielectric layer 301. A material of the second dummy pad 402 may be the same as that of the first dummy pad 401. In this way, when bonding (bonding) is performed on the first stacking component 21 and the second stacking component 22, a hybrid bonding (hybrid bonding) process may be used to bond the second dielectric layer 302 and the first dielectric layer 301, and bond one of the first dummy pads 401 and the second dummy pad 402 corresponding to a position of the first dummy pad 401.

It should be noted that bonding between chips is a process in which the chips are integrated through a van der Waals force, a molecular force, or even an atomic force generated by atoms at an interface between the chips under an action of external energy.

In addition, the third dielectric layer 303 is disposed on the active surface F of the second chip 212. The third dummy pads 403 are disposed in the third dielectric layer 303. The third dummy pads 403 are not coupled to the circuit structure 101 in the second chip 212.

As shown in FIG. 2a, the third stacking component 23 may include the third chip 213, a fourth dielectric layer 304, and a plurality of fourth dummy pads 404 arranged at intervals. As described above, the third chip 213 includes an active surface F and a passive surface B that are opposite to each other. The third chip 213 is disposed on a side on which the active surface F of the second chip 212 is located. The passive surface B of the third chip 213 faces the active surface F of the second chip 212.

In addition, the fourth dielectric layer 304 is disposed on the passive surface B of the third chip 213. The plurality of fourth dummy pads 404 are disposed in the fourth dielectric layer 304. One of the plurality of fourth dummy pads 404 corresponds to a position of one of the plurality of third dummy pads 403. The fourth dummy pads 404 are not coupled to the circuit structure 101 in the second chip 212.

As described above, materials of the third dielectric layer 303 and the fourth dielectric layer 304 may be the same as the material of the first dielectric layer 301. Materials of the third dummy pad 403 and the fourth dummy pad 404 may be the same as the material of the first dummy pad 401. In this case, when bonding is performed on the second stacking component 22 and the third stacking component 23, the foregoing hybrid bonding process may be used to bond the third dielectric layer 303 and the fourth dielectric layer 304, and bond one of the third dummy pads 403 and the fourth dummy pad 404 corresponding to a position of the third dummy pad 403.

On this basis, to enable signal transmission between the first chip 211 in the first stacking component 21 and the second chip 212, as shown in FIG. 2a, the first stacking component 21 may further include a first redistribution layer 501, the second stacking component 22 may further include a second conductive pad 522, a second redistribution layer 502, and a first via (through Si via, TSV) 511, and the third stacking component 23 further includes a third conductive pad 523.

The first redistribution layer 501 is disposed in the first dielectric layer 301 and coupled to the first chip 211. The first redistribution layer 501 includes a plurality of dielectric layers, and a metal trace disposed between two adjacent dielectric layers. Adjacent metal traces may be electrically connected through a via in the dielectric layer. In this case, that the first redistribution layer 501 is coupled to the first chip 211 means that the metal trace in the first redistribution layer 501 is coupled to the circuit structure 101 (as shown in FIG. 2b) in the first chip 211.

In addition, the second conductive pad 522 is disposed in the second dielectric layer 302 and coupled to the first redistribution layer 501. On this basis, the first stacking component 21 further includes a first conductive pad 521 shown in FIG. 2c (which shows a partial structure of the chip stacking structure 20). The first conductive pad 521 is disposed on a surface that is of the first redistribution layer 501 and that is away from the first chip 211, and coupled to the first redistribution layer 501, that is, the first conductive pad 521 is coupled to the metal trace in the first redistribution layer 501.

In this case, the first conductive pad 521 and the second conductive pad 522 may be bonded, so that the second conductive pad 522 is coupled to the metal trace in the first redistribution layer 501 through the first conductive pad 521, and strength of bonding between the first stacking component 21 and the second stacking component 22 is improved.

In addition, as shown in FIG. 2a, the second redistribution layer 502 is disposed in the third dielectric layer and coupled to the circuit structure 101 in the second chip 212. The first via 511 penetrates the second chip 212. A first end of the first via 511 is coupled to the second conductive pad 522. A second end of the first via 511 is coupled to the second redistribution layer 502. The third conductive pad 523 is disposed in the fourth dielectric layer 304 and coupled to a metal trace in the second redistribution layer 502. On this basis, the second stacking component 22 further includes a fourth conductive pad 524 shown in FIG. 2c. The fourth conductive pad 524 is disposed on a surface that is of the second redistribution layer 502 and that is away from the second chip 212, and coupled to the second redistribution layer 502, that is, the fourth conductive pad 524 is coupled to the metal trace in the second redistribution layer 502.

In this case, the fourth conductive pad 524 and the third conductive pad 523 may be bonded, so that the third conductive pad 523 is coupled to the metal trace in the second redistribution layer 502 through the fourth conductive pad 524, and strength of bonding between the third stacking component 23 and the second stacking component 22 is improved.

The third conductive pad 523 may be coupled to the circuit structure in the third chip 213. The third conductive pad 523 is disposed on a side on which the passive surface B of the third chip 213 is located, namely, a side that is of the substrate 100 in the third chip 213 and that is close to the first chip 211. Therefore, to connect the third conductive pad 523 to the circuit structure 101 in the third chip 213, a hole may be provided in the substrate 100 of the third chip 213, so that the third conductive pad 523 can be coupled to the circuit structure 101 in the third chip 213 through the hole in the substrate 100 of the third chip 213.

In this case, as shown in FIG. 2c, signal transmission can be implemented between the first chip 211 and the second chip 212 through the first redistribution layer 501, the first conductive pad 521, the second conductive pad 522, the first via 511, and the second redistribution layer 522. In addition, signal transmission can be implemented between the third chip 213 and the second chip 212 through the third conductive pad 523, the fourth conductive pad 524, and the second redistribution layer 502. Furthermore, signal transmission can be implemented between the third chip 213 and the first chip 211 through the third conductive pad 523, the fourth conductive pad 524, the second redistribution layer 502, the first via 511, the second conductive pad 522, and the first redistribution layer 501.

In this way, the first redistribution layer 501, the first conductive pad 521, the second conductive pad 522, the first via 511, the second redistribution layer 502, the fourth conductive pad 524, and the third conductive pad 523 may form a first interconnection component 50. Therefore, signal transmission is implemented between the first chip 211, the second chip 212, and the third chip 213 through the first interconnection component 50. In addition, because the first via 511 in the first interconnection component 50 penetrates the second chip 212 and the substrate 100 in the second chip 212 has a small thickness that may be approximately 50 µm, the first chip 211, the second chip 212, and the third chip 213 can be coupled in a longitudinal direction through the first interconnection component 50, so that a signal transmission path of the first chip 211, the second chip 212, and the third chip 213 is shorter. In this case, in comparison with a solution in which two or three side-by-side chips are coupled through a trace in a two-dimensional plane, a signal transmitted by the chip stacking structure 20 provided in this application can have higher bandwidth. This helps improve performance of the chip stacking structure.

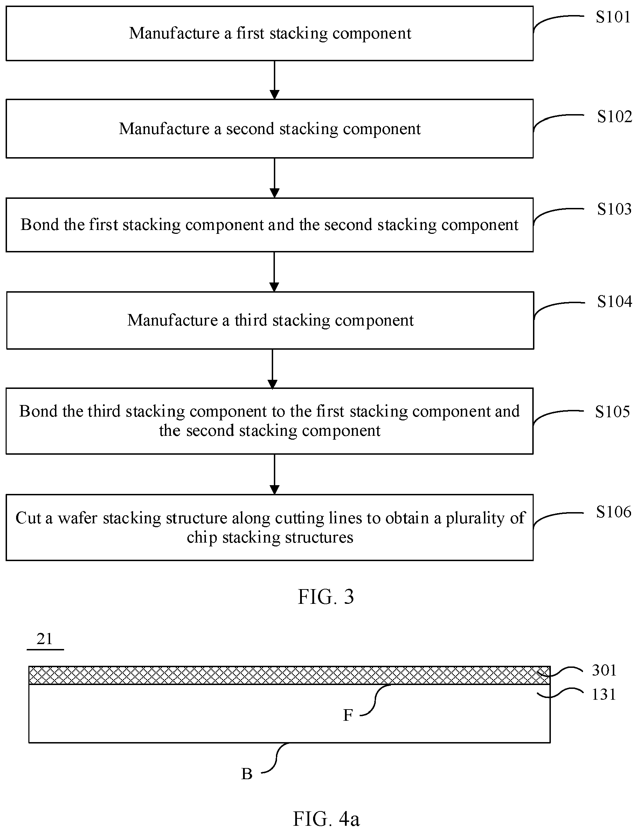

In embodiments of this application, the chip stacking structure 20 may be manufactured in a W2W bonding manner. The following describes a method for manufacturing the chip stacking structure 20 by using an example. As shown in FIG. 3, the method for manufacturing the chip stacking structure 20 may include S101 to S 106.

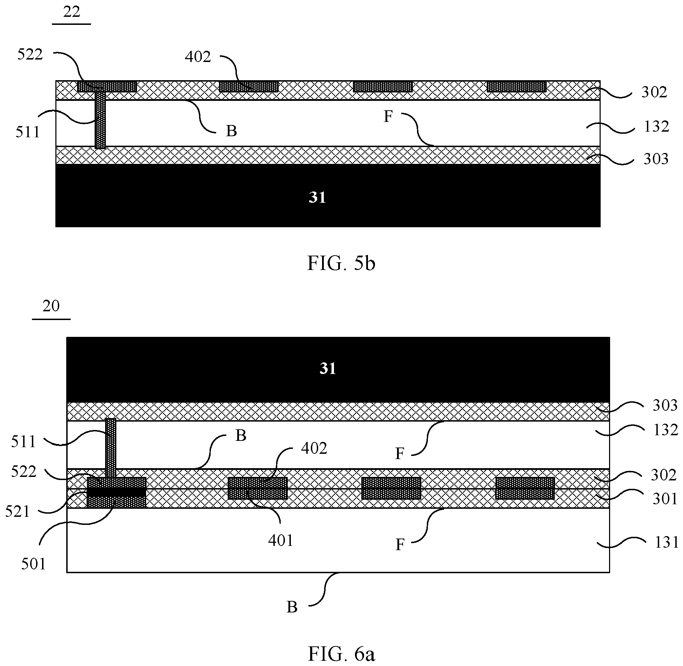

S101: Manufacture the first stacking component. S101 may include: disposing a second wafer 132 on a side on which an active surface F of a first wafer 131 shown in FIG. 4a is located (as shown in FIG. 6a). A passive surface B of the second wafer 132 faces the active surface F of the first wafer 131.

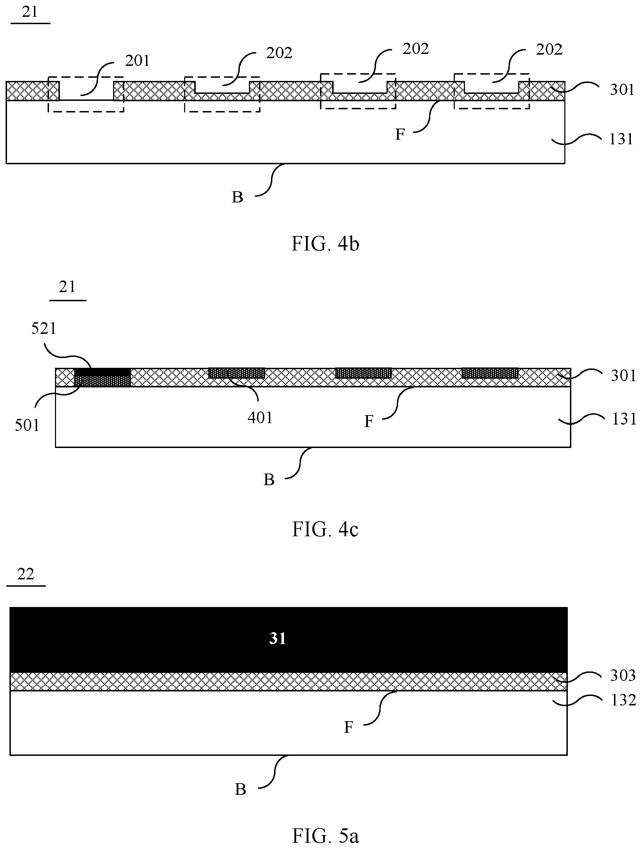

Specifically, as shown in FIG. 4a, the first wafer 131 is cleaned, and the first dielectric layer 301 is formed on the active surface F of the first wafer 131. Then, a first groove 201 and a plurality of second grooves 202 arranged at intervals shown in FIG. 4b are formed in the first dielectric layer 301 using a photoetching process. The active surface F of the first wafer 131 is exposed at the bottom of the first groove 201. The active surface F of the first wafer 131 is not exposed at the bottom of the second groove 202.

Specifically, the photoetching process includes: forming a photoresist layer (not shown in the figure) on a surface that is of the first dielectric layer 301 and that is away from the first wafer 131, pattern the photoresist layer through a mask (mask), and forming the first groove 201 and the second grooves 202 in the first dielectric layer 301 using an etching process.

Next, as shown in FIG. 4c, the first redistribution layer 501 coupled to the first wafer 131 is manufactured in the first groove 201. The first redistribution layer 501 is coupled to the circuit structure 101 (as shown in FIG. 2b) in the first wafer 131. Then, the first dummy pads 401 are manufactured in the second grooves 202. One of the first dummy pads 401 is located in one of the second grooves 201. In addition, when the first dummy pads 401 are manufactured, the first conductive pad 521 may also be manufactured on a surface that is of the first redistribution layer 501 and that is away from the first wafer 131. In this case, a material of the first conductive pad 521 may be the same as that of the first dummy pad 401.

It should be noted that a process for forming the conductive material in the grooves in the second dielectric layer 302 may include a chemical vapor deposition (chemical vapor deposition, CVD) process, a sputtering deposition process, an ion beam deposition process, a physical vapor deposition (physical vapor deposition, PVD) process, an atomic layer deposition process, molecular beam epitaxy (molecular beam epitaxy, MBE) vapor deposition, and electro-plating (electro-plating).

In addition, the first wafer 131 includes the substrate 100 and the circuit structure 101 shown in FIG. 2b. Furthermore, a plurality of cross cutting lines (not shown in the figure) are disposed on the first wafer 131. A region enclosed by adjacent cross cutting lines is a region in which the first chip 211 is located. After the first wafer 131 is cut along the cutting lines, a plurality of first chips 211 can be obtained.

S102: Manufacture the second stacking component 22. S102 includes the following steps:
As shown in FIG. 5a, the second wafer 132 is cleaned, and the third dielectric layer 303 is formed on an active surface F of the second wafer 132. Next, the wafer carrier plate 31 is bonded to a surface that is of the third dielectric layer 303 and that is away from the second wafer 132. As described above, after the second wafer 132 is cut along cutting lines on the second wafer 132, a plurality of second chips 212 can be obtained.

It should be noted that in embodiments of this application, the wafer carrier plate 31 may be made of a same material as the substrate of the wafer.

Next, as shown in FIG. 5b, the passive surface B (namely, a surface that is of the substrate 100 in the second wafer 132 and that is away from the circuit structure 101) of the second wafer 132 is thinned. Then, the second dielectric layer 302 is formed on the passive surface B of the second wafer 132.

Next, the first via 511 that penetrates the second wafer 132 may be formed using an etching process, for example, a dry etching process. Then, the second conductive pad 522 located at an end that is of the first via 511 and that is away from the wafer carrier plate 31 is formed in the second dielectric layer 302. The first end (namely, an end close to the second conductive pad 522) of the first via 511 is coupled to the second conductive pad 522. In addition, when the second conductive pad 522 is manufactured in the second dielectric layer 302, the plurality of second dummy pads 402 arranged at intervals may be formed in the second dielectric layer 302.

A material of the second conductive pad 522 may be the same as that of the second dummy pad 402. For example, the material is pure copper. In addition, a method for manufacturing the second conductive pad 522 and the second dummy pads 402 may be similar to that for manufacturing the first dummy pad 401. Details are not described herein again.

S103: Bond the first stacking component 21 and the second stacking component 22. S103 may include: bonding the first wafer 131 and the second wafer 132 using the hybrid bonding process.

Specifically, as shown in FIG. 6a, the hybrid bonding process is used to bond the second dielectric layer 302 and the first dielectric layer 301, and bond one of the second dummy pads 402 and one of the first dummy pads 401. Then, a grinding process, a chemical mechanical polishing process, or an etching process (dry etching or wet etching) may be used to remove the wafer carrier plate 31 shown in FIG. 6a.

In embodiments of this application, any dielectric layer, for example, the first dielectric layer 301, is made of an inorganic insulation material. In this application, no organic adhesive layer needs to be added in a process of bonding any two wafers. Therefore, a probability of organic impurity contamination caused by use of an organic material can be reduced in a process of manufacturing the chip stacking structure 20.

Furthermore, it can be learned from the foregoing description that the wafer carrier plate 31 can support the second wafer 132 in both a process of thinning the passive surface of the second wafer 132 and a process of bonding the passive surface B of the second wafer 132 and the active surface F of the first wafer 131, so that a probability that the second wafer 132 warps during the thinning and stacking with another wafer can be reduced. This can improve yields of a wafer stacking structure 02 and the chip stacking structure 20 formed by cutting the wafer stacking structure 02.

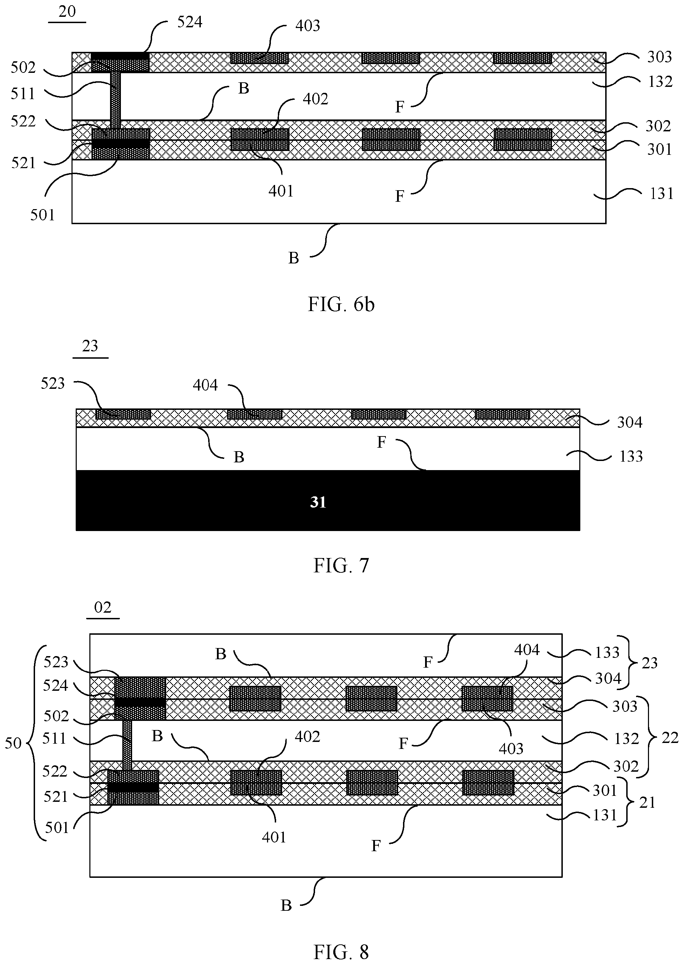

Next, S102 of manufacturing the second stacking component 22 further includes: as shown in FIG. 6b, forming the second redistribution layer 502 and the plurality of third dummy pads 403 arranged at intervals in the third dielectric layer 303. The second redistribution layer 502 is coupled to the second wafer 132 and the second end (an end close to the second redistribution layer 502) of the first via 511. A method for manufacturing the third dummy pads 403 is similar to that for manufacturing the first dummy pads 401. Details are not described herein again. In addition, it can be learned from the foregoing description that when the third dummy pads 403 are manufactured, the fourth conductive pad 524 may be formed on a surface that is of the second redistribution layer 502 and that is away from the second wafer 132.

S104: Manufacture the third stacking component 23. S104 may include: disposing a third wafer 133 on a side on which the active surface F of the second wafer 132 is located. A passive surface B of the third wafer 133 faces the active surface F of the second wafer 132.

Specifically, as shown in FIG. 7, the fourth dielectric layer 304 is formed on the passive surface B of the third wafer 133. The third conductive pad 523 and the plurality of fourth dummy pads 404 arranged at intervals are formed in the fourth dielectric layer 304. As described above, after the third wafer 133 is cut along cutting lines on the third wafer 133, a plurality of third chips 213 can be obtained.

S105: Bond the third stacking component 23 to the first stacking component 21 and the second stacking component 22.

Because the first stacking component 21 and the second stacking component 22 are already bonded, the wafer stacking structure 02 shown in FIG. 8 can be formed only by bonding the third wafer 133 and the second wafer 132 using the hybrid bonding process.

A method for bonding the third stacking component 23 and the second stacking component 22 includes: as shown in FIG. 8, using the hybrid bonding process to bond the fourth dielectric layer 304 and the third dielectric layer 303, and bond one of the fourth dummy pads 404 and one of the third dummy pads 403.

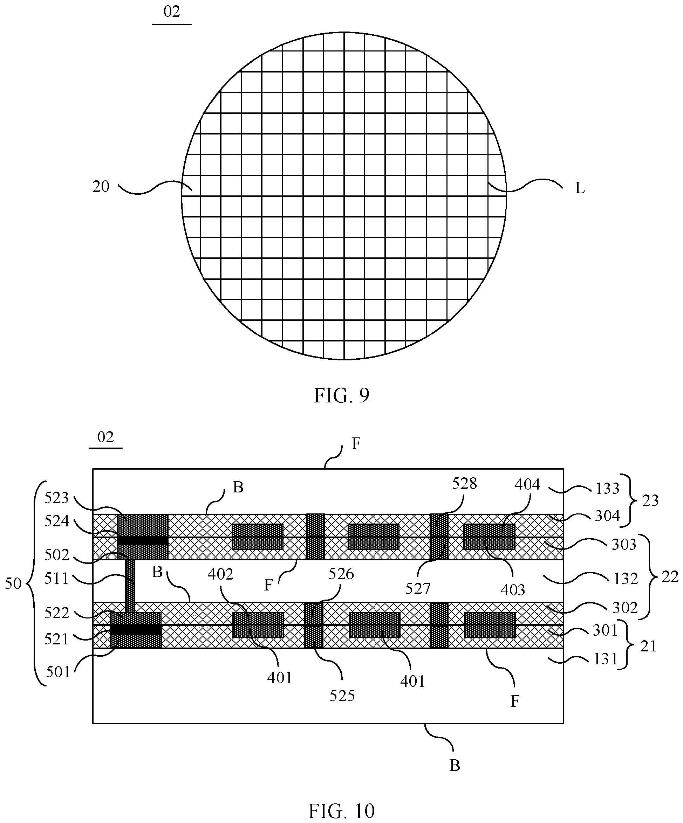

S106: Cut the wafer stacking structure 02 along cutting lines L shown in FIG. 9, to obtain a plurality of chip stacking structures 20. A longitudinal sectional view of the wafer stacking structure 02 is shown in FIG. 2c.

It should be noted that the cutting lines of the wafer stacking structure 02 may be cutting lines of a wafer located at an uppermost layer in the wafer stacking structure 02, for example, the third wafer 133 in FIG. 8. In addition, cutting lines of different wafers at identical positions may be aligned. Therefore, when the wafer stacking structure 02 is cut along the cutting lines of the wafer stacking structure 02, while the first wafer 131 is cut to obtain a plurality of first chips 211, a plurality of second chips 212 can be obtained by cutting the second wafer 132, and a plurality of third chips 213 can be obtained by cutting the third wafer 133.

In conclusion, to obtain the chip stacking structure 20, in the method for manufacturing the chip stacking structure 20 provided in embodiments of this application, the wafers in the plurality of stacking components are bonded through hybrid bonding to form the wafer stacking component 02. Specifically, two adjacent wafers are bonded through bonding between dielectric layers and bonding between metals. For example, bonding between the first wafer 131 in the first stacking component 21 and the second wafer 132 in the second stacking component 22 may be implemented by bonding the first dielectric layer 301 and the second dielectric layer 302 and bonding one of the first dummy pads 401 and one of the second dummy pads 402. Bonding between the second wafer 132 in the second stacking component 22 and the third wafer 133 in the third stacking component 23 may be implemented through insulation material bonding between the third dielectric layer 303 and the fourth dielectric layer 304 and metal material bonding between one of the third dummy pads 403 and one of the fourth dummy pads 404. Next, the wafer stacking structure 02 is cut to form the plurality of chip stacking structures 20.

The formed wafer stacking structure 02 is cut, so that the chip stacking structures 20 each with a plurality of stacked chips can be obtained. The chip stacking structure 20 can have high integration in the longitudinal direction (a direction perpendicular to the substrate 100 of any chip). A size of the chip stacking structure 20 in the two-dimensional plane is reduced, so that a component with high integration and performance can be provided in limited two-dimensional component layout space of the electronic device 01.

In addition, in the process of manufacturing the chip stacking structure provided in embodiments of this application, the first wafer 131 and the second wafer 132 may be sequentially stacked through wafer to wafer bonding. Next, the first stacking component 21 formed by the first wafer 131 and the second wafer 132 is bonded to the third wafer 133 through W2W bonding to form the wafer stacking structure 02. In this case, the wafer stacking structure 02 may be cut along cutting lines on an outermost wafer of the wafer stacking structure 02, to form the plurality of chip stacking structures 20. Therefore, in the process of manufacturing the chip stacking structure 20, alignment needs to be performed only on the wafers, but does not need to be performed on a single chip. This helps reduce alignment precision and improve production efficiency. In addition, in comparison with a D2D bonding solution and a D2W bonding solution, in the W2W bonding solution provided in embodiments of this application, the wafers are directly bonded and then cut to obtain the chip stacking structures 20. Therefore, there is no need to use a known good die KGD to test dies obtained through cutting one by one, so that a manufacturing process can be simplified and production costs can be reduced.

Furthermore, as shown in FIG. 10, after the first dielectric layer 301 is formed on the active surface F of the first wafer 131, the method for manufacturing the first stacking component 21 further includes: Manufacture a plurality of fifth conductive pads 525 arranged at intervals in the first dielectric layer 301. The fifth conductive pads 525 are coupled to the circuit structure 101 in the first wafer 131. In this case, after the wafer stacking structure 02 is cut, the fifth conductive pads 525 may be coupled to the circuit structure 101 in the first chip 211 obtained by cutting the first wafer 131. A material of the fifth conductive pad 525 may be the same as that of the first dummy pad 401. On this basis, to simplify the manufacturing process, the fifth conductive pads 525 may be manufactured while the first dummy pads 401 are manufactured.

In addition, after the second dielectric layer 302 is formed on the passive surface of the second wafer 132, the method for manufacturing the second stacking component 22 further includes: Manufacture a plurality of sixth conductive pads 526 arranged at intervals in the second dielectric layer 302. The sixth conductive pads 526 are electrically connected to the second wafer 132. It can be learned from the foregoing description that the second wafer 132 further includes the substrate 100 configured to carry the circuit structure 101. A surface that is of the substrate 100 and that is close to the second dielectric layer 302 is the passive surface B of the second wafer 132. Because the second dielectric layer 302 is manufactured on the passive surface B of the second wafer 132, to enable the sixth conductive pads 526 in the second dielectric layer 302 to be coupled to the circuit structure 101 in the second wafer 132, a hole may be provided in the substrate 100 of the second wafer 132, so that the sixth conductive pads 526 are coupled to the circuit structure 101 in the second wafer 132 through the hole in the substrate 100. Similarly, the sixth conductive pads 526 are electrically connected to the second chip 212 obtained by cutting the second wafer 132. A material of the sixth conductive pad 526 may be the same as that of the second dummy pad 402. On this basis, to simplify the manufacturing process, the sixth conductive pads 526 may be manufactured while the second dummy pads 402 are manufactured.

On this basis, bonding the first stacking component 21 and the second stacking component 22 further includes: As shown in FIG. 10, when the hybrid bonding process is used to bond the first dielectric layer 301 and the second dielectric layer 302 and bond one of the first dummy pads 401 and one of the second dummy pads 402, one of the plurality of fifth conductive pads 525 and one of the plurality of sixth conductive pads 526 may also be bonded. In this way, signal transmission can be implemented between the first wafer 131 and the second wafer 132 not only through the first interconnection component 50, but also through the fifth conductive pad 525 and the sixth conductive pad 526 that are coupled to each other. This can increase signal bandwidth of the chip stacking structure 20 formed by cutting the wafer stacking structure 02.

Similarly, as shown in FIG. 10, after the third dielectric layer 303 is formed on the active surface F of the second wafer 132, the method for manufacturing the second stacking component 22 further includes: Manufacture a plurality of seventh conductive pads 527 arranged at intervals in the third dielectric layer 303. The seventh conductive pads 527 are coupled to the circuit structure 101 in the second wafer 132. In this case, after the wafer stacking structure 02 is cut, the seventh conductive pads 527 may be coupled to the circuit structure 101 in the second chip 212 obtained by cutting the second wafer 132. A material of the seventh conductive pad 527 may be the same as that of the third dummy pad 403. On this basis, to simplify the manufacturing process, the seventh conductive pads 527 may be manufactured while the third dummy pads 403 are manufactured.

In addition, after the fourth dielectric layer 304 is formed on the passive surface B of the third wafer 133, the method for manufacturing the third stacking component 23 further includes: Manufacture a plurality of eighth conductive pads 528 arranged at intervals in the fourth dielectric layer 304. The eighth conductive pads 528 are electrically connected to the third wafer 133. Similarly, because the fourth dielectric layer 304 is manufactured on the passive surface B of the third wafer 133, to enable the eighth conductive pads 528 in the fourth dielectric layer 304 to be coupled to the circuit structure 101 in the third wafer 133, a hole may be provided in the substrate 100 of the third wafer 133, so that the eighth conductive pads 528 are coupled to the circuit structure 101 in the third wafer 133 through the hole in the substrate 100. Similarly, the eighth conductive pads 528 are electrically connected to the third chip 213 obtained by cutting the third wafer 133. A material of the eighth conductive pad 528 may be the same as that of the fourth dummy pad 404. On this basis, to simplify the manufacturing process, the eighth conductive pads 528 may be manufactured while the fourth dummy pads 404 are manufactured.

On this basis, bonding the second stacking component 22 and the third stacking component 23 further includes: As shown in FIG. 10, when the hybrid bonding process is used to bond the second dielectric layer 302 and the third dielectric layer 303 and bond one of the third dummy pads 403 and one of the fourth dummy pads 404, one of the plurality of seventh conductive pads 527 and one of the plurality of eighth conductive pads 528 may also be bonded. In this way, signal transmission can be implemented between the second wafer 132 and the third wafer 133 not only through the first interconnection component 50, but also through the seventh conductive pad 527 and the eighth conductive pad 528 that are coupled to each other. This can increase signal bandwidth of the chip stacking structure 20 formed by cutting the wafer stacking structure 02.

It should be noted that in embodiments of this application, a position of any bonded conductive pad group in the chip stacking structure 20 formed by cutting the wafer stacking structure 02 shown in FIG. 10 is not limited, such as a conductive pad group formed by the fifth conductive pad 525 and the sixth conductive pad 526, or a conductive pad group formed by the seventh conductive pad 527 and the eighth conductive pad 528. For example, the conductive pad group may be located between two adjacent dummy pads (for example, between the first dummy pads 401 in FIG. 10). Alternatively, in some other embodiments of this application, for a single chip stacking structure 20, compared with a dummy pad (for example, the first dummy pad 401), the bonded conductive pad group (for example, the fifth conductive pad 525 and the sixth conductive pad 526 that are bonded) may be disposed at a periphery of the chip stacking structure 20.

In conclusion, the first wafer 131 and the second wafer 132 in the wafer stacking structure are bonded using the hybrid bonding process. Therefore, the first wafer 131 and the second wafer 132 can be bonded not only through an insulation material (for example, the first dielectric layer 301 and the second dielectric layer 302), but also through a metal material (for example, the fifth conductive pad 525 and the sixth conductive pad 526). In comparison with a solution in which two wafers are bonded through a single material, for example, an insulation material, higher bonding strength can be achieved through hybrid bonding between the first wafer 131 and the second wafer 132. In addition, the metal material (for example, the fifth conductive pad 525 and the sixth conductive pad 526) through which the first wafer 131 and the second wafer 132 are bonded can further couple the first wafer 131 and the second wafer 132. Similarly, the second wafer 132 and the third wafer 133 are also bonded using the hybrid bonding process. Therefore, bonding strength is also high. In addition, the metal material (for example, the seventh conductive pad 527 and the eighth conductive pad 528) through which the second wafer 132 and the third wafer 133 are bonded can further couple the second wafer 132 and the third wafer 133. It can be learned from the foregoing description that the wafer stacking structure 02 further includes the first via 511 that penetrates the second wafer. The first via 511 can couple the first wafer 131 and the third wafer 133. In this way, because the first wafer 131 and the second wafer 132 can be coupled using the hybrid bonding process, and the second wafer 132 and the third wafer 133 can be coupled using the hybrid bonding process, the first wafer 131, the second wafer 132, and the third wafer 133 can be coupled by coupling the first wafer 131 and the third wafer 133 through the first via 511. In this way, there is no need to separately dispose an interconnection structure, for example, the via, between the first wafer 131 and the second wafer 132. There is also no need to separately dispose a via between the second wafer 132 and the third wafer 133. This can reduce a quantity of vias and space for disposing an interconnection structure in the wafer. In this way, in a 3D-IC stacking process, bonding strength of adjacent wafers is improved, and a problem of limited space for disposing an interconnection structure is resolved.

In some embodiments of this application, the chip stacking structure 20 obtained by cutting the wafer stacking structure 02 shown in FIG. 8 or FIG. 10 may be a complementary metal oxide semiconductor (complementary metal oxide semiconductor, CMOS) image sensor (CMOS image sensor, CIS). In this case, the first chip 211 obtained by cutting the first wafer 131 may be a logic chip. The second chip 212 obtained by cutting the second wafer 132 may be a memory chip, for example, a dynamic random access memory (dynamic random access memory, DRAM) chip. The third chip 213 obtained by cutting the third wafer 133 may be a pixel array circuit.

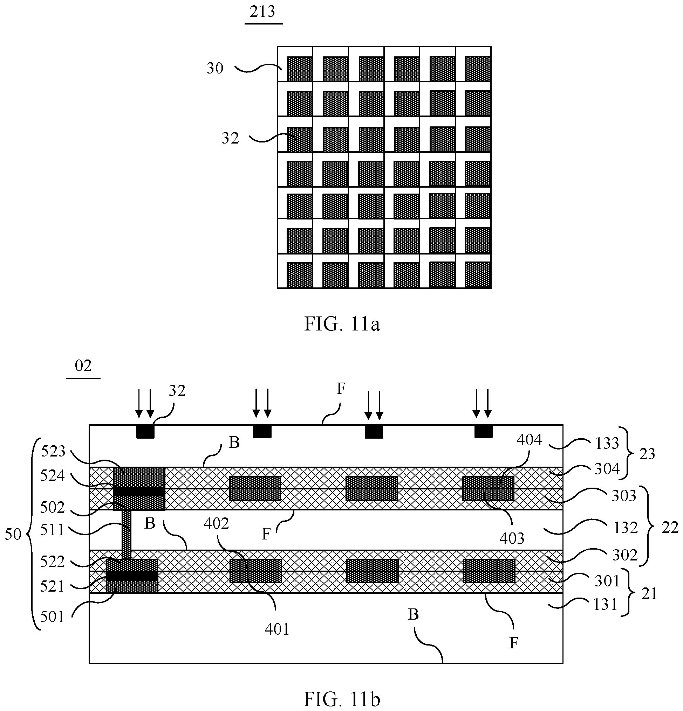

The pixel array circuit includes a plurality of photosensitive pixels (pixels) 30 shown in FIG. 11a and optical-to-electrical conversion elements 32 located in the photosensitive pixels 30. The optical-to-electrical conversion element 32 can receive ambient light (as shown by arrows in FIG. 11a), and convert the ambient light into an electrical signal. To enable the optical-to-electrical conversion element 32 to receive the ambient light, as shown in FIG. 11b, a light incidence surface of the optical-to-electrical conversion element 32 is disposed away from the second chip 212. In this way, a final actual photosensitive area of the chip stacking structure 20 can be increased while a same chip size is ensured because the memory chip, the logic chip, and the photosensitive pixels 30 in the pixel array circuit are not at a same layer.

In addition, to enable the chip stacking structure 20 obtained by cutting the wafer stacking structure 02 shown in FIG. 11b to be coupled to the external component 10, a hole may be provided in the third wafer 113 obtained by cutting the third wafer 133 in FIG. 11b, to expose the third conductive pad 523 in the first interconnection component 50. Next, a metal material is manufactured in the hole in the third wafer 113. The metal material is coupled to the third conductive pad 523. In this way, the external component 10 can be coupled to each chip in the chip stacking structure 20 through the metal material and the first interconnection component 50.

In some embodiments of this application, the third chip 213 in the third stacking component 23 may be referred to as a bottom chip. The bottom chip may be coupled to the external component 10 (as shown in FIG. 1), so that the chip stacking structure 20 can implement signal transmission with another chip or chip stacking structure on the PCB through the external component 10.

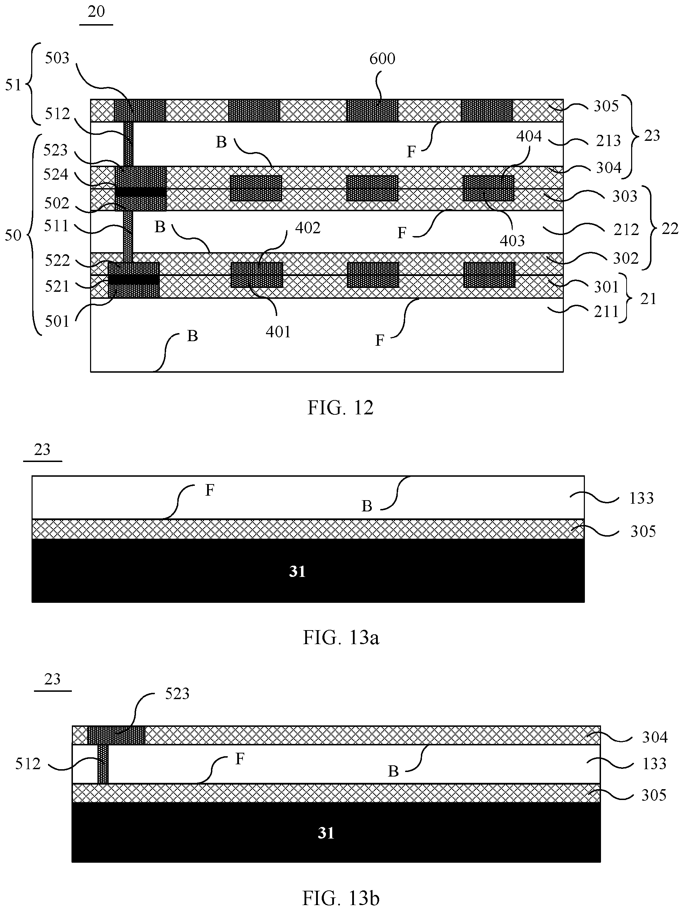

In this case, to enable the bottom chip (for example, the third chip 213) to be coupled to the external component 10, as shown in FIG. 12, the third stacking component 23 further includes a fifth dielectric layer 305, a plurality of interface pads 600 arranged at intervals, a third redistribution layer 503, and a second via 512.

The fifth dielectric layer 305 is disposed on an active surface of the third chip. The interface pads 600 are disposed in the fifth dielectric layer 305 and configured to be coupled to the external component 10. In this way, each chip in the chip stacking structure 20 can be coupled to the external component 10 through the interface pad 600.

In addition, the third redistribution layer 503 is disposed in the fifth dielectric layer 305 and coupled to the circuit structure 101 in the third chip 213 and the external component 10. The second via 512 penetrates the third chip 213. A first end of the second via 512 is coupled to the third conductive pad 523. A second end of the second via 512 is coupled to the third redistribution layer 503. In this way, the third redistribution layer 503 and the second via 512 may form a second interconnection component 51, so that the third chip 213 can implement signal transmission with the second chip 212 and the first chip 211 in the chip stacking structure 20 through the second interconnection component 51 and the first interconnection component 50 coupled to the second interconnection component 51. As described above, the second via 512 in the second interconnection component 51 penetrates the third chip 213. Therefore, the second chip 212 and the third chip 213 can be coupled in the longitudinal direction through the second interconnection component 51, so that a signal transmission path of the second chip 212 and the third chip 213 is shorter. This helps improve performance of the chip stacking structure.

The third chip 213 used as the bottom chip may be a logic chip. At least one chip (for example, the first chip 211 or the second chip 212) in the chip stacking structure 20 other than the bottom chip (for example, the third chip 213) may be a memory chip, for example, a DRAM chip. In this case, the chip stacking structure 20 may be a high bandwidth memory (high bandwidth memory, HBM).

In the method for manufacturing the chip stacking structure 20 shown in FIG. 12, the method for manufacturing the first stacking component 21, the method for manufacturing the second stacking component 22, and a method for bonding the first stacking component 21 and the second stacking component 22 are the same as those described above. Details are not described herein again. A difference lies in that before the fourth dielectric layer 304 is formed on the passive surface of the third wafer 133, the method for manufacturing the third stacking component 23 further includes the following steps:
First, as shown in FIG. 13a, the fifth dielectric layer 305 is formed on the active surface F of the third wafer 133, and the wafer carrier plate 31 is bonded to a surface that is of the fifth dielectric layer 305 and that is away from the third wafer 133. Then, the passive surface F of the third wafer 133 is thinned.

Next, as shown in FIG. 13b, after the fourth dielectric layer 304 is formed on the passive surface F of the third wafer 133, the second via 512 that penetrates the third wafer 133 is formed. In addition, the third conductive pad 523 located at an end that is of the second via 512 and that is away from the wafer carrier plate 31 is formed in the fourth dielectric layer 304. The first end of the second via 512 is coupled to the third conductive pad 523.

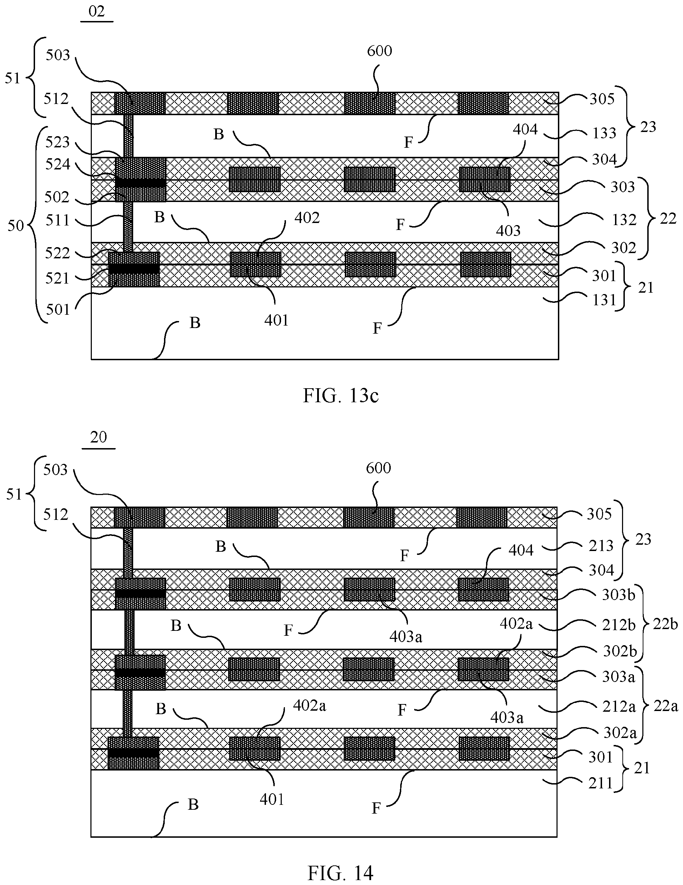

Next, after the fourth dielectric layer 304 and the third dielectric layer 303 (as shown in FIG. 6b) are bonded, the method for manufacturing the third stacking component 23 further includes: Remove the wafer carrier plate 31. As shown in FIG. 13c, form the third redistribution layer 503 in the fifth dielectric layer 305. The third redistribution layer 503 is coupled to the third chip 213 and the second end of the second via 512.

In addition, the plurality of interface pads 600 arranged at intervals may further be manufactured in the third redistribution layer 503, and are configured to be coupled to the external component 10. Finally, the wafer stacking structure 02 shown in FIG. 13c is cut to obtain a plurality of chip stacking structures 20 shown in FIG. 12.

It can be learned from the foregoing description that in the process of manufacturing the wafer stacking structure 02, any two adjacent wafers are stacked in a manner in which a passive surface B of one wafer is close to a front surface F of the other wafer, namely, a back to face (back to face, B2F) manner. For example, in FIG. 13c, the passive surface B of the second wafer 132 is close to a front surface F of the first wafer 131. The passive surface B of the third wafer 133 is close to a front surface F of the second wafer 132. In this way, orientations of the wafers are the same, so that positions of vias (for example, the first via 511 and the second via 512 in FIG. 13c) that are used to electrically connect different wafers and that penetrate different wafers may be the same. Therefore, a same mask (mask) can be used to manufacture a plurality of vias used for coupling at identical positions of different wafers, to avoid that a quantity of masks increases due to a mirror effect (mirror effect) when a face to face (face to face, F2F) solution is used.

It should be noted that the chip stacking structure 20 is described by using an example in which the chip stacking structure 20 includes one second stacking component 22. In some other embodiments of this application, the chip stacking structure 20 may include at least two second stacking components 22, for example, a lower second stacking component 22a and an upper second stacking component 22b that are sequentially away from the first stacking component 21, as shown in FIG. 14.

A second chip 212a in the lower second stacking component 22a and a second chip 212b in the upper second stacking component 22b may be bonded in the foregoing hybrid bonding manner. In this case, a third dielectric layer 303a in the lower second stacking component 22a is bonded to a second dielectric layer 302b in the upper second stacking component 22b. One third dummy pad 403a in the lower second stacking component 22a is bonded to one second dummy pad 402b in the upper second stacking component 22b.

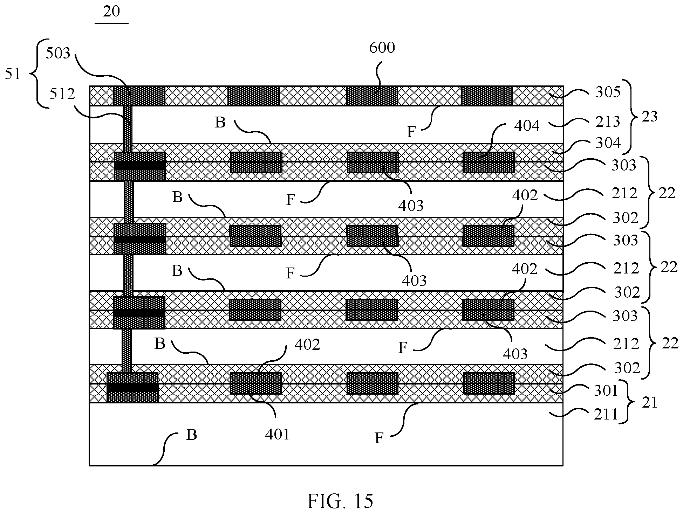

Alternatively, in some other embodiments of this application, the chip stacking structure 20 may include three second stacking components 22 shown in FIG. 15. A manner of bonding any two adjacent second stacking components 22 in the chip stacking structure 20 is the same as that of bonding the lower second stacking component 22a and the upper second stacking component 22b. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip stacking structure, comprising:
a first chip;
a second chip, disposed on a side on which an active surface of the first chip is located, wherein a passive surface of the second chip faces the active surface of the first chip, and the first chip and the second chip are bonded using a hybrid bonding process;
a third chip, disposed on a side on which an active surface of the second chip is located, wherein a passive surface of the third chip faces the active surface of the second chip, and the second chip and the third chip are bonded using the hybrid bonding process; and
a first via, penetrating the second chip, wherein a first end of the first via is coupled to the first chip, and a second end of the first via is coupled to the third chip.

2. The chip stacking structure according to claim 1, wherein the chip stacking structure further comprises:
a first dielectric layer, disposed on the active surface of the first chip;
a plurality of first dummy pads arranged at intervals, wherein the plurality of first dummy pads are disposed in the first dielectric layer;
a second dielectric layer, disposed on the passive surface of the second chip and bonded to the first dielectric layer;
a plurality of second dummy pads arranged at intervals, wherein the plurality of second dummy pads are disposed in the second dielectric layer, and one of the plurality of second dummy pads is bonded to one of the plurality of first dummy pads;
a third dielectric layer, disposed on the active surface of the second chip;
a plurality of third dummy pads arranged at intervals, wherein the plurality of third dummy pads are disposed in the third dielectric layer;
a fourth dielectric layer, disposed on the passive surface of the third chip and bonded to the third dielectric layer; and
a plurality of fourth dummy pads arranged at intervals, wherein the plurality of fourth dummy pads are disposed in the fourth dielectric layer, and one of the plurality of fourth dummy pads is bonded to one of the plurality of third dummy pads.

3. The chip stacking structure according to claim 2, wherein the chip stacking structure further comprises:
a first redistribution layer, disposed in the first dielectric layer and coupled to the first chip;
a second conductive pad, disposed in the second dielectric layer and coupled to the first redistribution layer;
a second redistribution layer, disposed in the third dielectric layer and coupled to the second chip; and
a third conductive pad, disposed in the fourth dielectric layer and coupled to the second redistribution layer and the third chip; wherein
the first end of the first via is coupled to the second conductive pad, and the second end of the first via is coupled to the second redistribution layer.

4. The chip stacking structure according to claim 3, wherein the chip stacking structure further comprises:
a first conductive pad, disposed on a surface that is of the first redistribution layer and that is away from the first chip, and coupled to the first redistribution layer, wherein the first conductive pad is bonded to the second conductive pad.

5. The chip stacking structure according to claim 3 or 4, wherein the chip stacking structure further comprises:
a fourth conductive pad, disposed on a surface that is of the second redistribution layer and that is away from the second chip, and coupled to the second redistribution layer, wherein the fourth conductive pad is bonded to the third conductive pad.

6. The chip stacking structure according to any one of claims 3 to 5, wherein the chip stacking structure further comprises:
a fifth dielectric layer, disposed on an active surface of the third chip;
a plurality of interface pads arranged at intervals, wherein the plurality of interface pads are disposed in the fifth dielectric layer and configured to be coupled to an external component;
a third redistribution layer, disposed in the fifth dielectric layer and coupled to the third chip; and
a second via, penetrating the third chip, wherein a first end of the second via is coupled to the third conductive pad, and a second end of the second via is coupled to the third redistribution layer.

7. The chip stacking structure according to claim 6, wherein the third chip is a logic chip; and at least one of the first chip or the second chip is a memory chip.

8. The chip stacking structure according to any one of claims 2 to 7, wherein the first chip is a logic chip; the second chip is a memory chip; and the third chip is a pixel array circuit; and
the pixel array circuit comprises a plurality of photosensitive pixels and optical-to-electrical conversion elements located in the photosensitive pixels; and light incidence surfaces of the optical-to-electrical conversion elements are disposed away from the second chip.

9. The chip stacking structure according to any one of claims 2 to 8, wherein the chip stacking structure further comprises:
a plurality of fifth conductive pads arranged at intervals, wherein the plurality of fifth conductive pads are disposed in the first dielectric layer and electrically connected to the first chip; and
a plurality of sixth conductive pads arranged at intervals, wherein the plurality of sixth conductive pads are disposed in the second dielectric layer and electrically connected to the second chip; wherein
one of the plurality of fifth conductive pads is bonded to one of the plurality of sixth conductive pads.

10. The chip stacking structure according to any one of claims 2 to 9, wherein the chip stacking structure further comprises:
a plurality of seventh conductive pads arranged at intervals, wherein the plurality of seventh conductive pads are disposed in the third dielectric layer and electrically connected to the second chip; and
a plurality of eighth conductive pads arranged at intervals, wherein the plurality of eighth conductive pads are disposed in the fourth dielectric layer and electrically connected to the third chip; wherein
one of the plurality of seventh conductive pads is bonded to one of the plurality of eighth conductive pads.

11. A wafer stacking structure, comprising:
a first wafer;
a second wafer, wherein the second wafer is disposed on a side on which an active surface of the first wafer is located, a passive surface of the second wafer faces the active surface of the first wafer, and the first wafer and the second wafer are bonded using a hybrid bonding process;
a third wafer, wherein the third wafer is disposed on a side on which an active surface of the second wafer is located, a passive surface of the third wafer faces the active surface of the second wafer, and the second wafer and the third wafer are bonded using the hybrid bonding process; and
a first via, penetrating the second wafer, wherein a first end of the first via is coupled to the first wafer, and a second end of the first via is coupled to the third wafer.

12. The wafer stacking structure according to claim 11, wherein the wafer stacking structure further comprises:
a first dielectric layer, disposed on the active surface of the first wafer;
a plurality of first dummy pads arranged at intervals, wherein the plurality of first dummy pads are disposed in the first dielectric layer;
a second dielectric layer, disposed on the passive surface of the second wafer and bonded to the first dielectric layer;
a plurality of second dummy pads arranged at intervals, wherein the plurality of second dummy pads are disposed in the second dielectric layer, and one of the plurality of second dummy pads is bonded to one of the plurality of first dummy pads;
a third dielectric layer, disposed on the active surface of the second wafer;
a plurality of third dummy pads arranged at intervals, wherein the plurality of third dummy pads are disposed in the third dielectric layer;
a fourth dielectric layer, disposed on the passive surface of the third wafer and bonded to the third dielectric layer;
and
a plurality of fourth dummy pads arranged at intervals, wherein the plurality of fourth dummy pads are disposed in the fourth dielectric layer, and one of the plurality of fourth dummy pads is bonded to one of the plurality of third dummy pads.

13. The wafer stacking structure according to claim 12, wherein the wafer stacking structure further comprises:
a first redistribution layer, disposed in the first dielectric layer and coupled to the first wafer;
a second conductive pad, disposed in the second dielectric layer and coupled to the first redistribution layer;
a second redistribution layer, disposed in the third dielectric layer and coupled to the second wafer; and
a third conductive pad, disposed in the fourth dielectric layer and coupled to the second redistribution layer and the third wafer; wherein
the first end of the first via is coupled to the second conductive pad, and the second end of the first via is coupled to the second redistribution layer.

14. An electronic device, comprising an external component and at least one chip stacking structure according to any one of claims 1 to 10 coupled to the external component.

15. The electronic device according to claim 14, wherein the external component comprises at least one of the following: a package substrate, an interposer, or at least one redistribution layer of a fan-out package.

16. A method for manufacturing a wafer stacking structure, wherein the method comprises:
disposing a second wafer on a side on which an active surface of a first wafer is located and bonding the first wafer and the second wafer using a hybrid bonding process, wherein a passive surface of the second wafer faces the active surface of the first wafer;
disposing a third wafer on a side on which an active surface of the second wafer is located and bonding the third wafer and the second wafer using the hybrid bonding process, wherein a passive surface of the third wafer faces the active surface of the second wafer; and
forming a first via that penetrates the second wafer, wherein a first end of the first via is coupled to the first wafer, and a second end of the first via is coupled to the third wafer.

17. The method for manufacturing a wafer stacking structure according to claim 16, wherein
the disposing a second wafer on a side on which an active surface of a first wafer is located and bonding the first wafer and the second wafer using a hybrid bonding process comprises:
forming a first dielectric layer on the active surface of the first wafer, and forming a plurality of first dummy pads arranged at intervals in the first dielectric layer;
forming a third dielectric layer on the active surface of the second wafer, bonding a wafer carrier plate to a surface that is of the third dielectric layer and that is away from the second wafer, and thinning the passive surface of the second wafer;
forming a second dielectric layer on the passive surface of the second wafer, and forming a plurality of second dummy pads arranged at intervals in the second dielectric layer;
bonding the second dielectric layer and the first dielectric layer, bonding one of the plurality of second dummy pads and one of the plurality of first dummy pads, and removing the wafer carrier plate; and
forming a plurality of third dummy pads arranged at intervals in the third dielectric layer; and
the disposing a third wafer on a side on which an active surface of the second wafer is located and bonding the third wafer and the second wafer using the hybrid bonding process comprises:
forming a fourth dielectric layer on the passive surface of the third wafer, and forming a plurality of fourth dummy pads arranged at intervals in the fourth dielectric layer; and
bonding the fourth dielectric layer and the third dielectric layer, and bonding one of the plurality of fourth dummy pads and one of the plurality of third dummy pads.

18. The method for manufacturing a wafer stacking structure according to claim 16 or 17, wherein after the third wafer and the second wafer are bonded, the method further comprises: cutting the first wafer, the second wafer, and the third wafer along cutting lines

19. The method for manufacturing a wafer stacking structure according to claim 17, wherein
after the first dielectric layer is formed on the active surface of the first wafer, the method for manufacturing the wafer stacking structure further comprises: forming a first redistribution layer in the first dielectric layer;
after the second dielectric layer is formed on the passive surface of the second wafer and the first via is formed, the method for manufacturing the wafer stacking structure further comprises:
forming, in the second dielectric layer, a second conductive pad located at an end that is of the first via and that is away from the wafer carrier plate, wherein the first end of the first via is coupled to the second conductive pad;
after the third dielectric layer is formed on the active surface of the second wafer, the method for manufacturing the wafer stacking structure further comprises: forming a second redistribution layer in the third dielectric layer, wherein the second redistribution layer is coupled to the second wafer and the second end of the first via; and
after the fourth dielectric layer is formed on the passive surface of the third wafer, the method for manufacturing the wafer stacking structure further comprises: forming a third conductive pad in the fourth dielectric layer, wherein the third conductive pad is coupled to the second redistribution layer.

20. The method for manufacturing a wafer stacking structure according to claim 17, wherein
before the fourth dielectric layer is formed on the passive surface of the third wafer, the method for manufacturing the wafer stacking structure further comprises: forming a fifth dielectric layer on an active surface of the third wafer, bonding the wafer carrier plate to a surface that is of the fifth dielectric layer and that is away from the third wafer, and thinning the passive surface of the third wafer;
after the fourth dielectric layer is formed on the passive surface of the third wafer, a second via that penetrates the third wafer is formed, and a third conductive pad located at an end that is of the second via and that is away from the wafer carrier plate is formed in the fourth dielectric layer; and a first end of the second via is coupled to the third conductive pad; and
after the fourth dielectric layer and the third dielectric layer are bonded, the method for manufacturing the wafer stacking structure further comprises: removing the wafer carrier plate, and forming a third redistribution layer in the fifth dielectric layer, wherein the third redistribution layer is coupled to the third wafer and a second end of the second via.
